# EUROPEAN PATENT APPLICATION

(11) **EP 4 769 856 A1**
(43) Date of publication of application: **01.07.2026**
(21) Application number: 25224451.2
(22) Date of filing: 17.12.2025
(51) Int. Cl.: H02G 3/08, H01R 13/52, H02G 15/013, H05K 5/06

(54) **WATERPROOF FIXING DEVICE AND ELECTRONIC DEVICE WITH SAME**

(30) Priority: 31.12.2024 CN 202411999173
(71) Applicant: Delta Electronics (Thailand) Public Company Limited, Samutprakarn 10280 (TH)
(72) Inventor: Peng, Xu, Shanghai, 201209 (CN); Liao, Yongkai, Shanghai, 201209 (CN); Jiang, Qing, Shanghai, 201209 (CN)
(74) Representative: Uexküll & Stolberg

(57) **Abstract**

A waterproof fixing device (2) and an electronic device (100) with the waterproof fixing device (2) are provided. The waterproof fixing device (2) includes a cable (3), a first sealing element (4) and a second sealing element (5). The first sealing element (4) is sheathed around the outer surface (31) of the cable (3). The first sealing element (4) and the second sealing element (5) are assembled with each other and tightly fitted in the through hole (12) of the housing (1) of the electronic device (100) to achieve the waterproof purpose. In accordance with the waterproof fixing device (2) of the present disclosure, fewer components are used, the assembled structure is simple, the assembly time is reduced, and the sealing effect between the cable (3) and the through hole (12) of the housing (1) is enhanced. Consequently, the overall waterproof performance is improved.

## Description

### FIELD OF THE INVENTION

The present disclosure relates to a fixing device, and more particularly to a waterproof fixing device and an electronic device with the waterproof fixing device.

### BACKGROUND OF THE INVENTION

For various electronic devices operating in outdoor environments, the overall waterproof performance is not only a critical design criterion but also an essential practical requirement. Generally, after a cable is penetrated through a through hole in the housing of the electronic device, a gap is formed between the cable and the inner periphery of the through hole. Consequently, external moisture or water vapor readily enters the interior of the housing. Therefore, it is important to provide a mechanism for securing the cable at the through hole of the housing in a waterproof manner.

In order to meet the waterproof requirements of the cable in the aforementioned parts, many electronic devices adopt a dispensing (potting) technology or the combination of the dispensing technology and an SR (Strain Relief) tail card design, or complex mechanisms involving a large number of components.

For example, a cable equipped with an SR tail card can be combined with a specially designed housing to fix the cable to achieve waterproof purpose. However, this design is not highly versatile. It is only applicable to the housing structure with separate upper/lower parts, and this design is not suitably applied to a housing with a single circular through hole. Moreover, the upper part and the lower part of the housing corresponding to the through hole have to be equipped with corresponding engaging structures to be engaged with the SR tail card structure on the cable. Due to this design, the structure of the electronic device is more complex, and design cost is significantly increased.

Moreover, in some other electronic devices, a cable gland is used to fix the cable in the through hole of the housing to achieve the waterproof purpose. Although the cable gland can provide good sealing and protecting capacity, the structure of the cable gland is complicated. Generally, the cable gland includes a plurality of seals, stress-reducing components, and waterproof and dustproof materials. However, the use of the cable gland requires a large number of components. Consequently, the installation process becomes more complicated, and the construction time and labor cost increase. In addition, since the high-quality cable glands usually use durable materials to achieve good corrosion resistance and durability, the material cost increases.

Therefore, there is a need of providing a waterproof fixing device and an electronic device with the waterproof fixing device in order to overcome the drawbacks of the conventional technologies.

### SUMMARY OF THE INVENTION

The present disclosure provides a waterproof fixing device and an electronic device with the waterproof fixing device. The waterproof fixing device includes a cable, a first sealing element and a second sealing element. The first sealing element is sheathed around the outer surface of the cable. The first sealing element and the second sealing element are assembled with each other and tightly fitted in the through hole of the housing of the electronic device to achieve the waterproof purpose. In accordance with the waterproof fixing device of the present disclosure, fewer components are used, the assembled structure is simple, the assembly time is reduced, and the sealing effect between the cable and the through hole of the housing is enhanced. Consequently, the overall waterproof performance is improved. Moreover, the waterproof fixing device can be applied to different types of through holes, such as the through holes with chamfers or counterbores. In addition, the waterproof fixing device has high adaptability to various wall thicknesses of the housing. Consequently, the applications are wide.

In accordance with an aspect of the present disclosure, a waterproof fixing device is provided. The waterproof fixing device includes a cable, a first sealing element and a second sealing element. The cable has an outer surface. The first sealing element includes a fixing component and a flexible component. The fixing component includes an inner ring structure, an outer ring structure and an accommodation space, wherein the inner ring structure has a first channel. The cable is penetrated through the first channel. The outer ring structure is connected to and arranged around the inner ring structure, and the accommodation space is located between the inner ring structure and the outer ring structure. The flexible component is assembled with the fixing component, wherein at least a portion of the flexible component is attached on the outer surface of the cable. The second sealing element includes a tubular portion. The tubular portion includes a wall structure. The wall structure is accommodated within the accommodation space of the first sealing element. In addition, an inner surface and an outer surface of the wall structure are respectively attached on an outer surface of the inner ring structure and an inner surface of the outer ring structure.

In accordance with an aspect of the present disclosure, an electronic device is provided. The electronic device includes a housing and a waterproof fixing device. The housing includes a side wall. The side wall has a through hole. The waterproof fixing device is assembled with the housing. The waterproof fixing device includes a cable, a first sealing element and a second sealing element. The cable has an outer surface. The first sealing element includes a fixing component and a flexible component. The fixing component includes an inner ring structure, an outer ring structure and an accommodation space, wherein the inner ring structure has a first channel. The cable is penetrated through the first channel. The outer ring structure is connected to and arranged around the inner ring structure, and the accommodation space is located between the inner ring structure and the outer ring structure. The flexible component is assembled with the fixing component, wherein at least a portion of the flexible component is attached on the outer surface of the cable. The second sealing element includes a tubular portion. The tubular portion includes a wall structure. The wall structure is accommodated within the accommodation space of the first sealing element. In addition, an inner surface and an outer surface of the wall structure are respectively attached on an outer surface of the inner ring structure and an inner surface of the outer ring structure. The cable of the waterproof fixing device is extended through the through hole of the side wall of the housing, and the first sealing element is fitted and fixed into the through hole of the side wall of the housing.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a structural diagram illustrating an electronic device with a waterproof fixing device according to a first embodiment of the present disclosure;
FIG. 2A is a structural diagram illustrating a first sealing element of the waterproof fixing device according to the first embodiment of the present disclosure;
FIG. 2B is a structural diagram illustrating a fixing component of the first sealing element of the waterproof fixing device according to the first embodiment of the present disclosure;
FIG. 2C is a structural section drawing illustrating the fixing component as shown in FIG. 2B and taken along the cross section A-A';
FIG. 2D is a structural diagram illustrating a flexible component of the first sealing element of the waterproof fixing device according to the first embodiment of the present disclosure;
FIG. 2E is a structural diagram illustrating a second sealing element of the waterproof fixing device according to the first embodiment of the present disclosure;
FIG. 2F is a structural section drawing illustrating the second sealing element as shown in FIG. 2E and taken along the cross section B-B';
FIG. 2G is a structural diagram illustrating the relationship between the waterproof fixing device and the housing of the electronic device according to the first embodiment of the present disclosure;
FIG. 2H is a structural section drawing illustrating the relationship between the waterproof fixing device and the housing of the electronic device according to the first embodiment of the present disclosure;
FIG. 2I is a schematic cross-sectional view illustrating the assembled structure of the waterproof fixing device and the housing of the electronic device according to the first embodiment of the present disclosure;
FIG. 3A is a structural section drawing illustrating the assembled structure of a waterproof fixing device and a housing of an electronic device according to a second embodiment of the present disclosure, in which the cable is not shown;
FIG. 3B is a schematic cross-sectional view illustrating the assembled structure of the waterproof fixing device and the housing of the electronic device according to the second embodiment of the present disclosure;
FIG. 4A is a structural diagram illustrating the relationship between a waterproof fixing device and a housing of an electronic device according to a third embodiment of the present disclosure;
FIG. 4B is a schematic cross-sectional view illustrating the assembled structure of the waterproof fixing device and the housing of the electronic device according to the third embodiment of the present disclosure;
FIG. 5A is a structural diagram illustrating the relationship between a waterproof fixing device and a housing of an electronic device according to a fourth embodiment of the present disclosure;
FIG. 5B is a structural section drawing illustrating the assembled structure of the waterproof fixing device and the housing of the electronic device according to the fourth embodiment of the present disclosure;
FIG. 5C is a schematic cross-sectional view illustrating the assembled structure of the waterproof fixing device and the housing of the electronic device according to the fourth embodiment of the present disclosure;
FIG. 6A is a structural diagram illustrating a first sealing element of a waterproof fixing device according to a fifth embodiment of the present disclosure;
FIG. 6B is a structural diagram illustrating the relationship between the waterproof fixing device and a housing of the electronic device according to the fifth embodiment of the present disclosure;
FIG. 6C is a schematic cross-sectional view illustrating the assembled structure of the waterproof fixing device and a housing of the electronic device according to the fifth embodiment of the present disclosure;
FIG. 7A is a structural section drawing illustrating the relationship between a waterproof fixing device and a housing of an electronic device according to a sixth embodiment of the present disclosure;
FIG. 7B is a schematic cross-sectional view illustrating the assembled structure of the waterproof fixing device and the housing of the electronic device according to the sixth embodiment of the present disclosure;
FIG. 8A is a structural diagram illustrating the assembled structure of a waterproof fixing device and a housing of an electronic device according to a seventh embodiment of the present disclosure; and
FIG. 8B is a structural section drawing illustrating assembled structure of the waterproof fixing device and the housing of electronic device according to the seventh embodiment of the present disclosure.

### DETAILED DESCRIPTION OF THE PREFERRED EMBODIMENT

The present disclosure will now be described more specifically with reference to the following embodiments. It is noted that the following descriptions of the preferred embodiments of the present disclosure are presented herein for purpose of illustration and description only. It is not intended to be exhaustive or to be limited to the precise from disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed. Further, spatially relative terms, such as "upper," "lower," "top," "bottom," "front," "rear" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first", "second", "third" and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments.

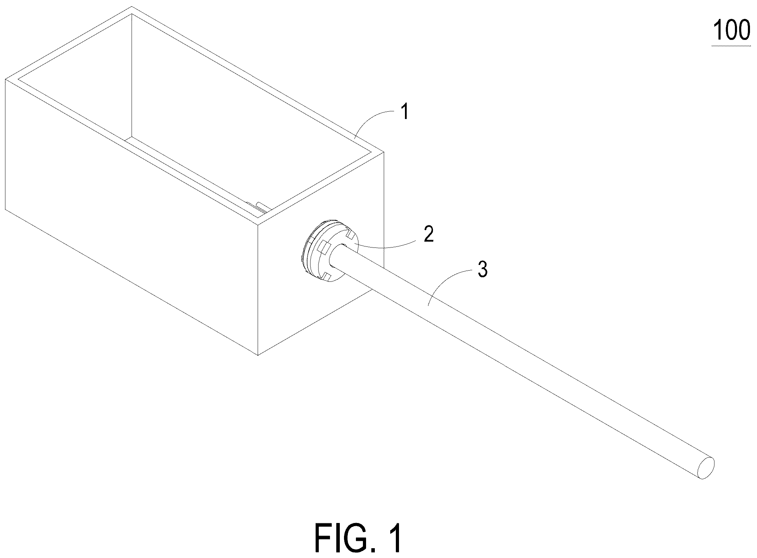

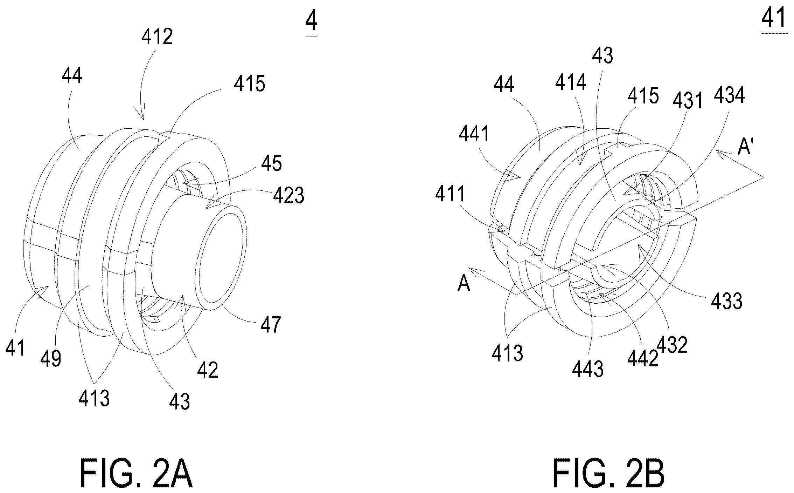

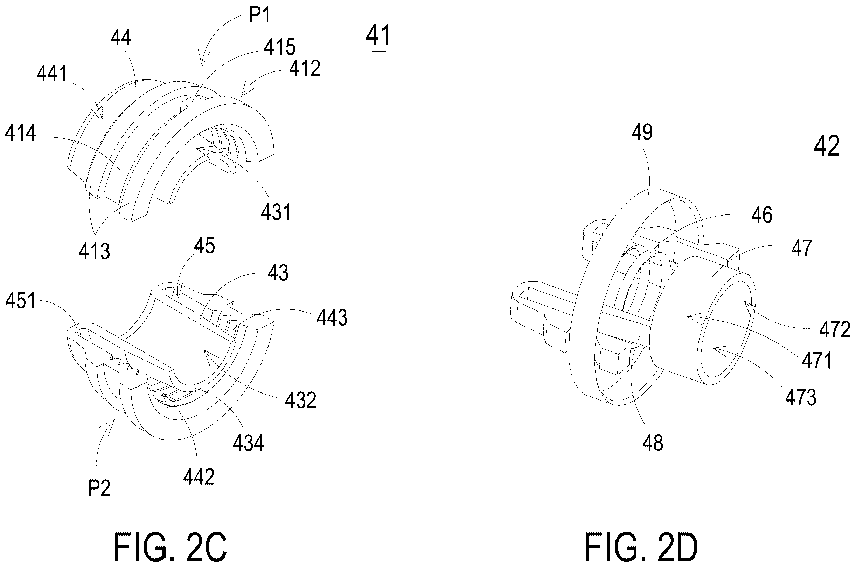

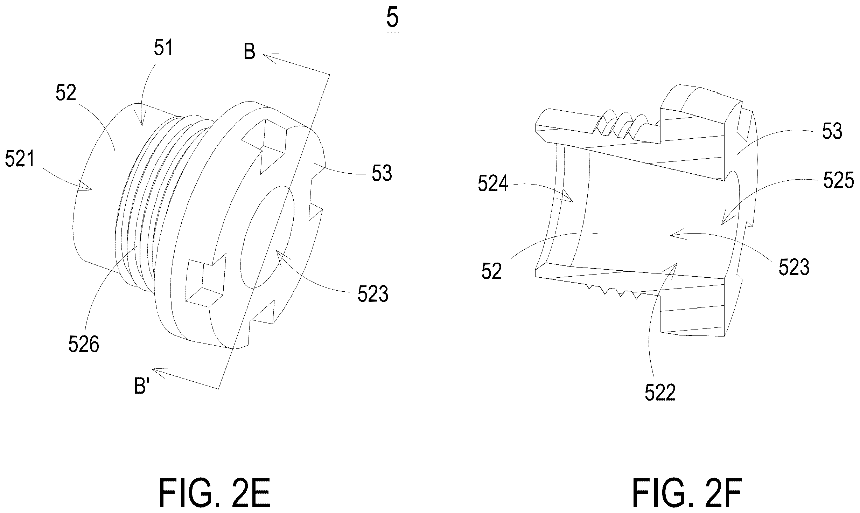

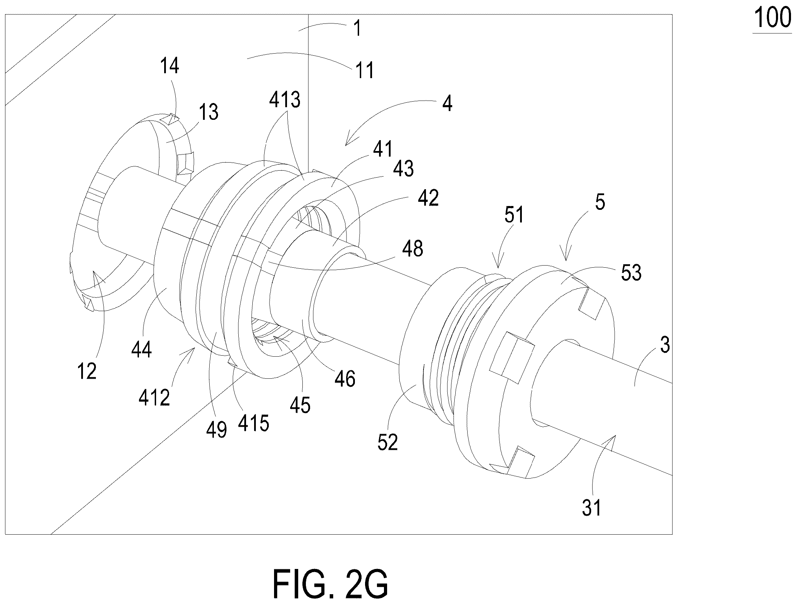

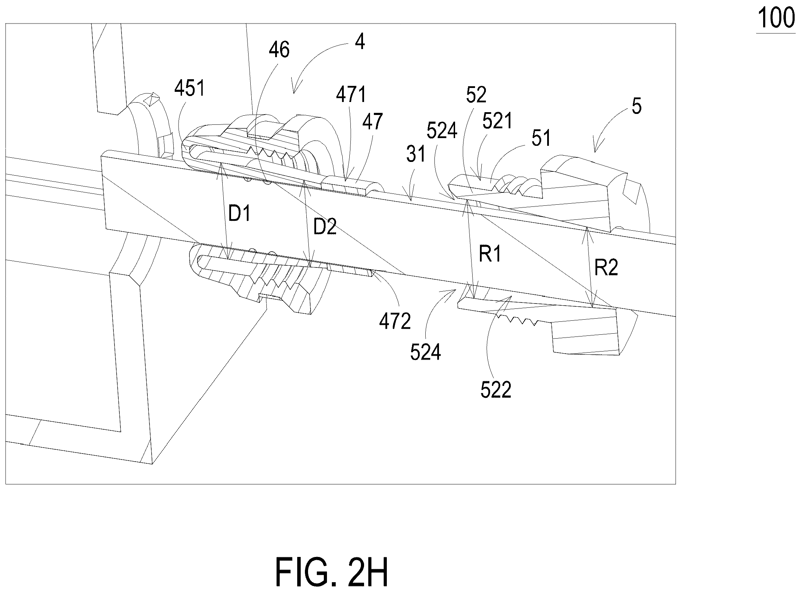

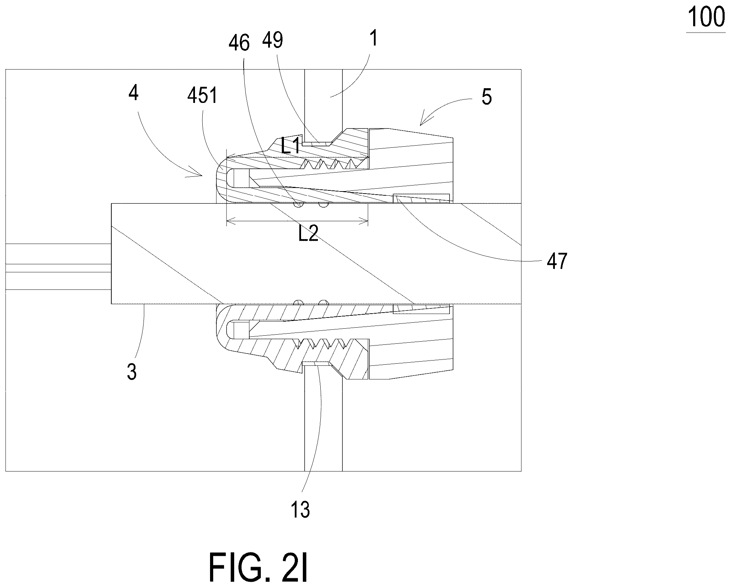

FIG. 1 is a structural diagram illustrating an electronic device with a waterproof fixing device according to a first embodiment of the present disclosure. FIG. 2A is a structural diagram illustrating a first sealing element of the waterproof fixing device according to the first embodiment of the present disclosure. FIG. 2B is a structural diagram illustrating a fixing component of the first sealing element of the waterproof fixing device according to the first embodiment of the present disclosure. FIG. 2C is a structural section drawing illustrating the fixing component as shown in FIG. 2B and taken along the cross section A-A'. FIG. 2D is a structural diagram illustrating a flexible component of the first sealing element of the waterproof fixing device according to the first embodiment of the present disclosure. FIG. 2E is a structural diagram illustrating a second sealing element of the waterproof fixing device according to the first embodiment of the present disclosure. FIG. 2F is a structural section drawing illustrating the second sealing element as shown in FIG. 2E and taken along the cross section B-B'. FIG. 2G is a structural diagram illustrating the relationship between the waterproof fixing device and the housing of the electronic device according to the first embodiment of the present disclosure. FIG. 2H is a structural section drawing illustrating the relationship between the waterproof fixing device and the housing of the electronic device according to the first embodiment of the present disclosure. FIG. 2I is a schematic cross-sectional view illustrating the assembled structure of the waterproof fixing device and the housing of the electronic device according to the first embodiment of the present disclosure.

Please refer to FIGS. 1, 2A, 2B, 2C, 2D, 2E, 2F, 2G, 2H and 2I. In this embodiment, the electronic device 100 includes a housing 1 and a waterproof fixing device 2. The housing 1 includes a side wall 11. The side wall 11 has a through hole 12. The waterproof fixing device 2 is assembled with the housing 1. The waterproof fixing device 2 includes a cable 3, a first sealing element 4 and a second sealing element 5. The cable 3 has an outer surface 31. The first sealing element 4 is sleeved onto the outer surface 31 of the cable 3. The first sealing element 4 includes a fixing component 41 and a flexible component 42. The fixing component 41 includes an inner ring structure 43, an outer ring structure 44 and an accommodation space 45. The inner ring structure 43 has a first channel 433. The cable 3 is penetrated through the first channel 433. The outer ring structure 44 is connected to and arranged around the inner ring structure 43. The accommodation space 45 is located between the inner ring structure 43 and the outer ring structure 44. The flexible component 42 is assembled with the fixing component 41. In addition, at least a portion of the flexible component 42 is attached on the outer surface 31 of the cable 3. The second sealing element 5 includes a tubular portion 51. The tubular portion 51 includes a wall structure 52. The wall structure 52 is accommodated within the accommodation space 45 of the first sealing element 4. Furthermore, an inner surface 522 and an outer surface 521 of the wall structure 52 are respectively attached on an outer surface 431 of the inner ring structure 43 and an inner surface 442 of the outer ring structure 44. The cable 3 of the waterproof fixing device 2 is extended through the through hole 12 of the side wall 11 of the housing 1, and the first sealing element 4 is tightly fitted into the through hole 12 of the side wall 11 of the housing 1. Consequently, the cable 3 can be fixed on the through hole 12 of the side wall 11 of the housing 1 with the assistance of the first sealing element 4 and the second sealing element 5 to achieve the waterproof purpose.

In some embodiments, the fixing component 41 of the first sealing element 4 further includes a connecting portion 451. The connecting portion 451 is connected between the inner ring structure 43 and the outer ring structure 44. The inner ring structure 43, the outer ring structure 44 and the connecting portion 451 are collaboratively formed the accommodation space 45. In addition, the accommodation space 45 is an annular groove.

Please refer to FIGS. 2A, 2G, 2H and 2I again. In this embodiment, the flexible component 42 is assembled with inner ring structure 43 and the outer ring structure 44 of the fixing component 41. The flexible component 42 includes a first waterproof structure 46. The first waterproof structure 46 is disposed on and arranged around the inner surface 432 of the inner ring structure 43. In addition, the first waterproof structure 46 is attached on the outer surface 31 of the cable 3 to fix the cable 3 and achieve the waterproof purpose. In some embodiments, the first waterproof structure 46 is an annular structure or a sheet-like structure. In some embodiments, the flexible component 42 includes two first waterproof structures 46. It is noted that the number of the first waterproof structures 46 may be varied according to the practical requirement.

In some embodiments, the flexible component 42 further includes a second waterproof structure 47. The second waterproof structure 47 is disposed on an end 434 of the inner ring structure 43 and extended in a direction parallel to an axial direction of the first channel 433. The second waterproof structure 47 has a hollow space 473. The hollow space 473 is in communication with the first channel 433 of the inner ring structure 43. In addition, a portion of the cable 3 is accommodated within the hollow space 473. An inner surface 472 and an outer surface 471 of the second waterproof structure 47 are respectively attached on the outer surface 31 of the cable 3 and the inner surface 522 of the wall structure 52 of the tubular portion 51. When the first sealing element 4 and the second sealing element 5 are assembled with each other, the second waterproof structure 47 is clamped between the outer surface 31 of the cable 3 and the inner surface 522 of the wall structure 52 of the tubular portion 51. In addition, the second waterproof structure 47 is subjected to deformation. In response to the deformation, the gap between the outer surface 31 of the cable 3 and the inner surface 522 of the wall structure 52 of the tubular portion 51 is tightly sealed. Consequently, the waterproof performance is enhanced. In an embodiment, the second waterproof structure 47 is an annular structure. In an embodiment, the first waterproof structure 46 and the second waterproof structure 47 are two separate components. Alternatively, in some other embodiments, the first waterproof structure 46 and the second waterproof structure 47 are connected with each other, and are integrally formed as a one-piece structure.

In some embodiments, the flexible component 42 further includes a waterproof ring 49. The waterproof ring 49 is arranged around an outer surface 441 of the outer ring structure 44. In addition, the waterproof ring 49 is attached on an inner periphery 13 of the through hole 12 of the side wall 1. Since the waterproof ring 49 is clamped between the fixing component 41 of the first sealing element 4 and the inner periphery 13 of the through hole 12 of the housing 1, the space between the first sealing element 4 and the inner periphery 13 of the through hole 12 of the housing 1 is effectively sealed. Consequently, the cable 3 can be securely fixed in the through hole 12 of the housing 1 to achieve the waterproof purpose. In an embodiment, the first waterproof structure 46, the second waterproof structure 47 and the waterproof ring 49 are separate components. In some other embodiments, the first waterproof structure 46, the second waterproof structure 47 and the waterproof ring 49 are connected with each other, and are integrally formed as a one-piece structure.

In some embodiments, the fixing component 41 of the first sealing element 4 further includes a first arc-shaped portion P1 and a second arc-shaped portion P2. The first arc-shaped portion P1 and the second arc-shaped portion P2 are separated from each other. In addition, a gap 411 is formed between the first arc-shaped portion P1 and the second arc-shaped portion P2. A portion of the inner ring structure 43, a portion of the outer ring structure 44 and a portion of the accommodation space 45 are collaboratively formed as the first arc-shaped portion P1, and another portion of the inner ring structure 43, another portion of the outer ring structure 44 and another portion of the accommodation space 45 are collaboratively formed as the second arc-shaped portion P2. The flexible component 42 further includes a third waterproof structure 48. The third waterproof structure 48 is disposed within the gap 411 and attached on the outer surface 31 of the cable 3 to enhance the waterproof performance. In this embodiment, the first arc-shaped portion P1 and the second arc-shaped portion P2 are made of metallic material, plastic material or elastic material.

In some embodiments, the third waterproof structure 48 is served as a connecting structure. The third waterproof structure 48 is connected with the first waterproof structure 46, the second waterproof structure 47 and the waterproof ring 49, thereby integrally forming a one-piece structure. In some embodiments, the flexible component 42 is made of silicone, rubber, or thermoplastic polyurethane (TPU). In some embodiments, the third waterproof structure 48 is attached on the outer surface 31 of the cable 3 to enhance the waterproof performance.

In this embodiment, the fixing component 41 of the first sealing element 4 further includes a limiting structure 412. The limiting structure 412 is disposed on an outer surface 441 of the outer ring structure 44. The limiting structure 412 includes two protrusions 413 and a groove 414. The two protrusions 413 are protruded from the outer surface 441 of the outer ring structure 44 and arranged around the outer ring structure 44. The groove 414 is defined by the two protrusions 413 and the outer surface 441 of the outer ring structure 44. In some embodiments, the waterproof ring 49 of the flexible component 42 is circumferentially disposed in the groove 414 of the limiting structure 412. In addition, the waterproof ring 49 is arranged between the two protrusions 413. When the first sealing element 4 and the second sealing element 5 are combined with each other and installed in the through hole 12 of the side wall 11 of the housing 1, the side wall 11 at the position neighboring the through hole 12 is tightly clamped by the two protrusions 413 of the limiting structure 412 of the first sealing element 4. Consequently, the first sealing element 4 is fixed in the through hole 12 of the side wall 11 of the housing 1. Since the waterproof ring 49 of the flexible component 42 is clamped between the inner periphery 13 of the through hole 12 of the housing 1 and the fixing component 41 of the first sealing element 4, the fixing and sealing effects are generated. In some embodiments, the width of the groove 414 is substantially equal to the thickness of the side wall 11 neighboring the through hole 12 of the housing 1. Especially, the width of the groove 414 can be varied according to the thickness of the side wall 11 of the housing 1. Consequently, the waterproof fixing device 2 can be adaptively applied to the housings 1 with different wall thicknesses, and the applications will be expanded.

In some embodiments, the limiting structure 412 of the fixing component 41 further includes at least one first limiting portion 415. The first limiting portion 415 is extended form one of the two protrusions 413 and towards the groove 414. The housing 1 further includes at least one second limiting portion 14 corresponding to the at least one first limiting portion 415. The second limiting portion 14 is arranged on an inner periphery 13 of the through hole 12 of the side wall 11. The first limiting portion 415 of the fixing component 41 and the second limiting portion 14 of the housing 1 are engaged with each other. Consequently, the first sealing element 4 is fixed and positioned on the housing 1. In an embodiment, the first limiting portion 415 is a protrusion, and the second limiting portion 14 is a groove. It is noted that numerous modifications may be made. For example, in another embodiment, the first limiting portion 415 is a groove, and the second limiting portion 14 is a protrusion.

In some embodiments, the outer ring structure 44 and the inner ring structure 43 of the first sealing element 4 in the direction parallel to the axial direction of the first channel 433 have a first length L1 and a second length L2, respectively. In this embodiment, the first length L1 and the second length L2 are equal.

Please refer to FIGS. 2A, 2B, 2G, 2H and 2I again. In some embodiments, the second sealing element 5 further includes a protruding top portion 53. The protruding top portion 53 is connected with an end of the tubular portion 51. When the second sealing element 5 and the first sealing element 4 are assembled with each other, the protruding top portion 53 of the second sealing element 5 is attached on an end of the outer ring structure 44 of the fixing component 41 to improve the sealing performance. The tubular portion 51 of the second sealing element 5 further includes a second channel 523. The second channel 523 runs through the tubular portion 51. The inner ring structure 43 of the fixing component 41 is accommodated within the second channel 523.

In some embodiments, the fixing component 41 of the first sealing element 4 further includes a connecting portion 451. The connecting portion 451 is connected between the inner ring structure 43 and the outer ring structure 44. A first end of the outer surface 431 of the inner ring structure 43 close to the connecting portion 451 has a first outer diameter D1, and a second end of the outer surface 431 of the inner ring structure 43 away from the connecting portion 451 has a second outer diameter D2. The first outer diameter D1 is greater than the second outer diameter D2. In some embodiments, the inner ring structure 43 is an annular conical structure. The second channel 523 of the tubular portion 51 of the second sealing element 5 includes a first opening 524 and a second opening 525, which are opposed to each other. The first opening 524 is away from the protruding top portion 53, and the second opening 525 is located near the protruding top portion 53. The first opening 524 has a first inner diameter R1. The second opening 525 has a second inner diameter R2. The first inner diameter R1 is greater than the second inner diameter R2. In some embodiments, the tubular portion 51 is an annular conical structure. When the first sealing element 4 and the second sealing element 5 are assembled with each other, the first sealing element 4 and the second sealing element 5 can be tightly combined together because the inner ring structure 43 and the tubular portion 51 have the matching annular conical structures. In an embodiment, the first inner diameter R1 and the first outer diameter D1 are substantially equal, and the second inner diameter R2 and the second outer diameter D2 are substantially equal. Due to this design, the outer surface 431 of the inner ring structure 43 of the first sealing element 4 can be tightly attached on the inner surface 522 of the wall structure 52 of the tubular portion 51 of the second sealing element 5. Consequently, the waterproof performance is improved.

In some embodiments, the outer surface 521 of the wall structure 52 of the tubular portion 51 of the second sealing element 5 has an external thread 526, and the inner surface 442 of the outer ring structure 44 of the first sealing element 4 has an internal thread 443. The external thread 526 and the internal thread 443 are engaged with each other. Consequently, the second sealing element 5 is assembled with the first sealing element 4, and the waterproof performance is enhanced.

In some embodiments, after the fixing component 41 and the flexible component 42 are subjected to a secondary injection molding process, the first sealing element 4 is formed. In some embodiments, the through hole 12 of the side wall 11 of the housing 1 is a circular through hole.

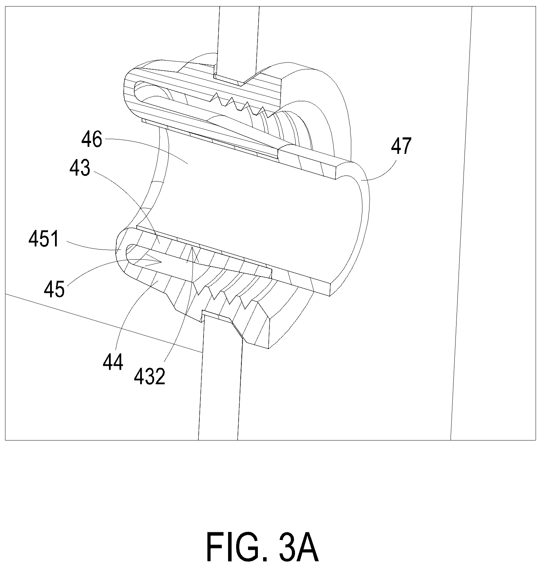

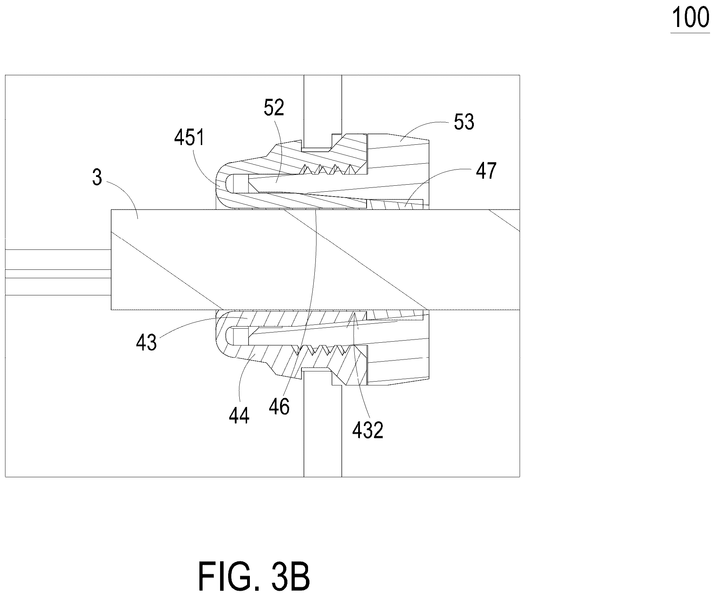

FIG. 3A is a structural section drawing illustrating the assembled structure of a waterproof fixing device and a housing of an electronic device according to a second embodiment of the present disclosure, in which the cable is not shown. FIG. 3B is a schematic cross-sectional view illustrating the assembled structure of the waterproof fixing device and the housing of the electronic device according to the second embodiment of the present disclosure.

Please refer to FIGS. 3A and 3B. The structures and functions of the waterproof fixing device and the electronic device of this embodiment are similar to those of the first embodiment. Component parts and elements corresponding to those of the first embodiment are designated by identical numeral references, and detailed descriptions thereof are omitted. In the waterproof fixing device of this embodiment, the flexible component 42 includes a single first waterproof structure 46 and a second waterproof structure 47. The inner surface 432 of the inner ring structure 43 is completely covered by the first waterproof structure 46. In addition, the first waterproof structure 46 and the second waterproof structure 47 are connected with each other and integrally formed as a one-piece structure. Due to the structural design of the flexible component 42, the contact area between the first sealing element 4 and the outer surface 31 of the cable 3 is large enough to enhance the waterproof performance. In some embodiments, the first waterproof structure 46 has an annular structure or a sheet-like structure that covers a portion of the inner surface 432 of the inner ring structure 43.

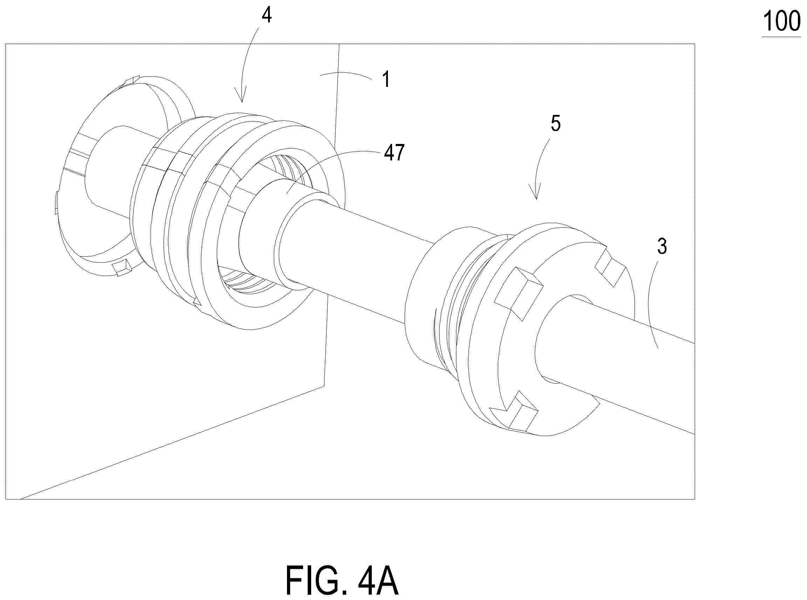

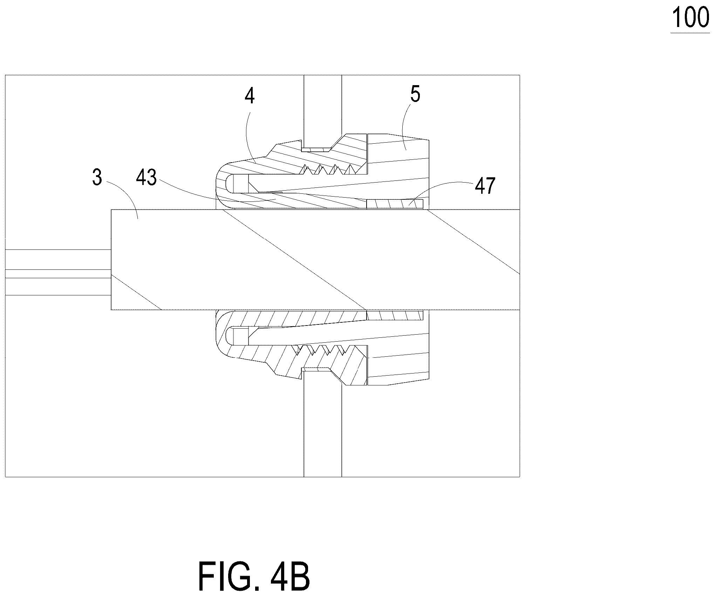

FIG. 4A is a structural diagram illustrating the relationship between a waterproof fixing device and a housing of an electronic device according to a third embodiment of the present disclosure. FIG. 4B is a schematic cross-sectional view illustrating the assembled structure of the waterproof fixing device and the housing of the electronic device according to the third embodiment of the present disclosure.

Please refer to FIGS. 4A and 4B. The structures and functions of the waterproof fixing device and the electronic device of this embodiment are similar to those of the first embodiment. Component parts and elements corresponding to those of the first embodiment are designated by identical numeral references, and detailed descriptions thereof are omitted. In the waterproof fixing device of this embodiment, the flexible component 42 is not equipped with the first waterproof structure 46, but the second waterproof structure 47 is retained. Due to this design, the required material of the flexible component 42 is reduced, and the fabricating cost and the processing complexity are thus reduced.

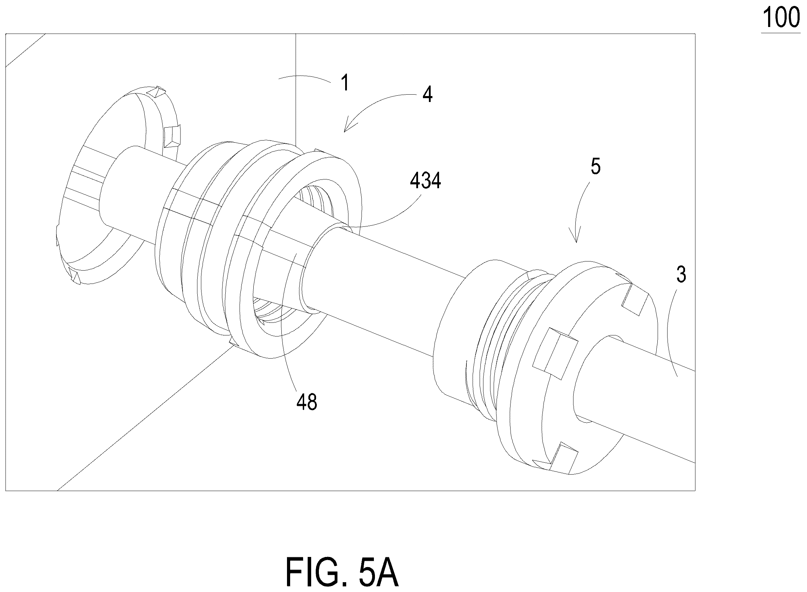

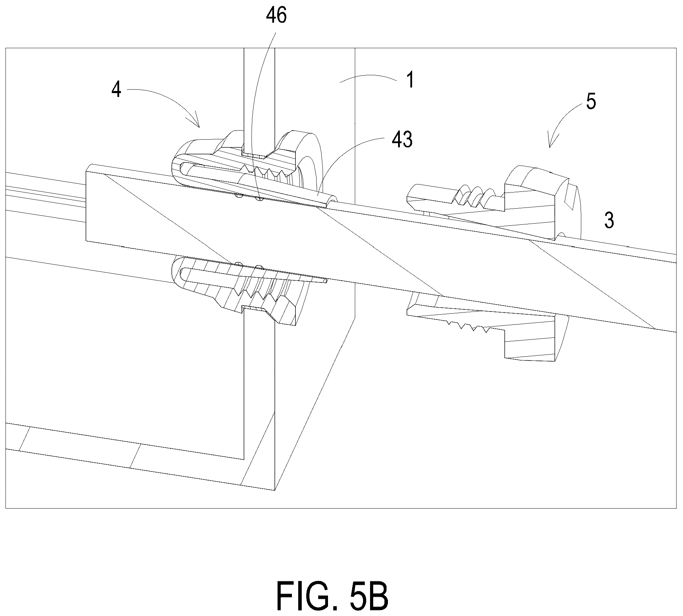

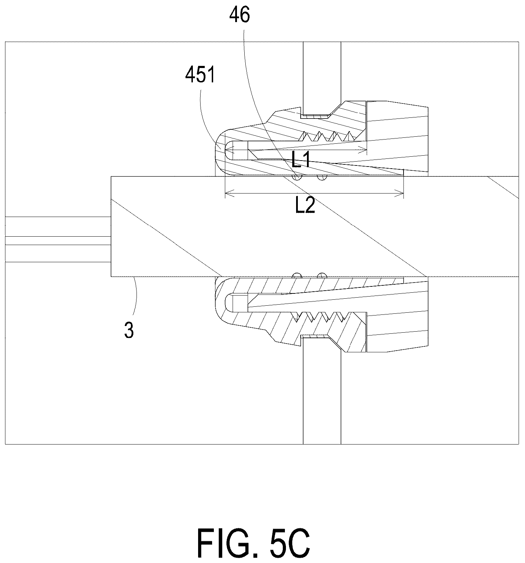

FIG. 5A is a structural diagram illustrating the relationship between a waterproof fixing device and a housing of an electronic device according to a fourth embodiment of the present disclosure. FIG. 5B is a structural section drawing illustrating the assembled structure of the waterproof fixing device and the housing of the electronic device according to the fourth embodiment of the present disclosure. FIG. 5C is a schematic cross-sectional view illustrating the assembled structure of the waterproof fixing device and the housing of the electronic device according to the fourth embodiment of the present disclosure.

Please refer to FIGS. 5A, 5B and 5C. The structures and functions of the waterproof fixing device and the electronic device of this embodiment are similar to those of the first embodiment. Component parts and elements corresponding to those of the first embodiment are designated by identical numeral references, and detailed descriptions thereof are omitted. In the waterproof fixing device of this embodiment, the flexible component 42 is equipped with the first waterproof structure 46, but the second waterproof structure 47 is omitted. Especially, the end 434 of the inner ring structure 43 and the corresponding end of the outer ring structure 44 are not aligned with each other. That is, the first length L1 and the second length L2 are not equal. For example, as shown in FIG. 5C, the end 434 of the inner ring structure 43 is protruded over the corresponding end of the outer ring structure 44. That is, the first length L1 is shorter than the second length L2. In this embodiment, the required material and the fabricating cost are reduced, and the processing complexity is also reduced. In addition, since the contact area between the outer surface 431 of the inner ring structure 43 and the inner surface 522 of the wall structure 52 is large enough to improve the waterproof performance. It is noted that numerous modifications may be made. For example, in another embodiment, the end 434 of the inner ring structure 43 is aligned with the corresponding end of the outer ring structure 44. That is, the first length L1 and the second length L2 are equal.

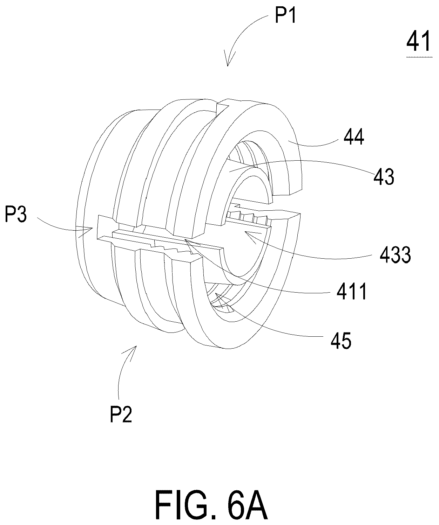

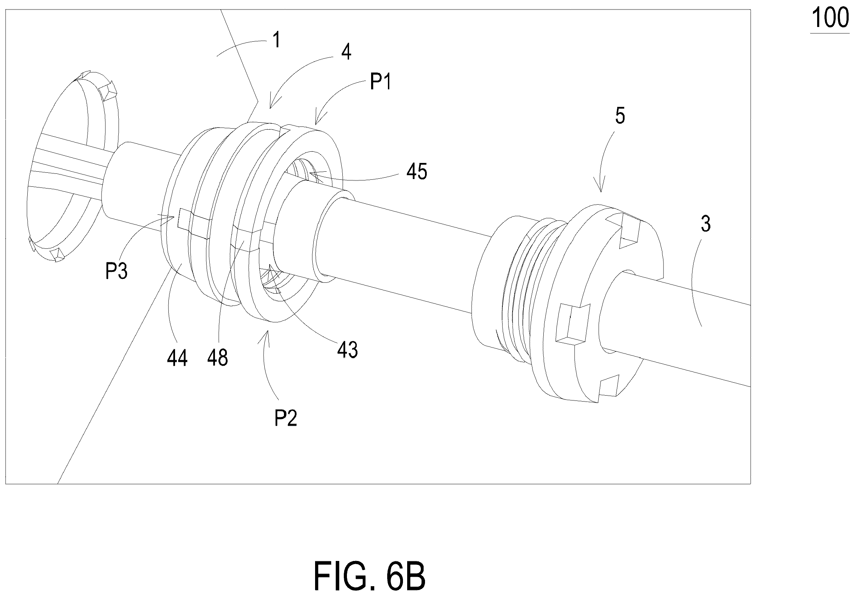

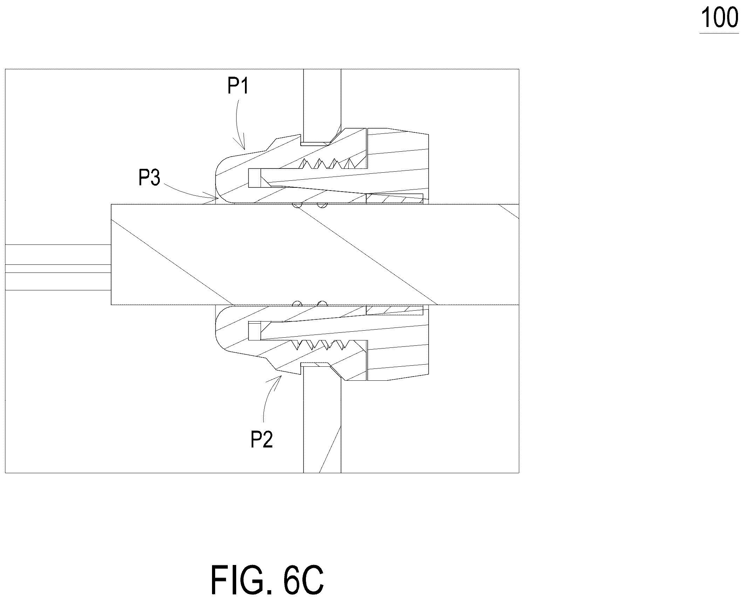

FIG. 6A is a structural diagram illustrating a first sealing element of a waterproof fixing device according to a fifth embodiment of the present disclosure. FIG. 6B is a structural diagram illustrating the relationship between the waterproof fixing device and a housing of the electronic device according to the fifth embodiment of the present disclosure. FIG. 6C is a schematic cross-sectional view illustrating the assembled structure of the waterproof fixing device and a housing of the electronic device according to the fifth embodiment of the present disclosure.

Please refer to FIGS. 6A, 6B and 6C. The structures and functions of the waterproof fixing device and the electronic device of this embodiment are similar to those of the first embodiment. Component parts and elements corresponding to those of the first embodiment are designated by identical numeral references, and detailed descriptions thereof are omitted. In the waterproof fixing device and the electronic device of this embodiment, the fixing component 41 of the first sealing element 4 includes a first arc-shaped portion P1, a second arc-shaped portion P2 and a connecting structure P3. The connecting structure P3 is connected between the first arc-shaped portion P1 and the second arc-shaped portion P2. In addition, there is a gap 411 between the first arc-shaped portion P1 and the second arc-shaped portion P2. The first arc-shaped portion P1, the second arc-shaped portion P2 and the connecting structure P3 are collaboratively formed as a one-piece structure. A portion of the inner ring structure 43, a portion of the outer ring structure 44 and a portion of the accommodation space 45 are collaboratively formed as the first arc-shaped portion P1, and another portion of the inner ring structure 43, another portion of the outer ring structure 44 and another portion of the accommodation space 45 are collaboratively formed as the second arc-shaped portion P2. In some embodiments, the flexible component 42 further includes a third waterproof structure 48. The third waterproof structure 48 is disposed within the gap 411 and attached on the outer surface 31 of the cable 3. In some embodiments, the first arc-shaped portion P1 and the second arc-shaped portion P2 are made of plastic material or elastic material. Of course, the way of connecting the first arc-shaped portion P1, the second arc-shaped portion P2 and the connecting structure P3 and the shape profiles of these structures can be modified according to the practical requirements.

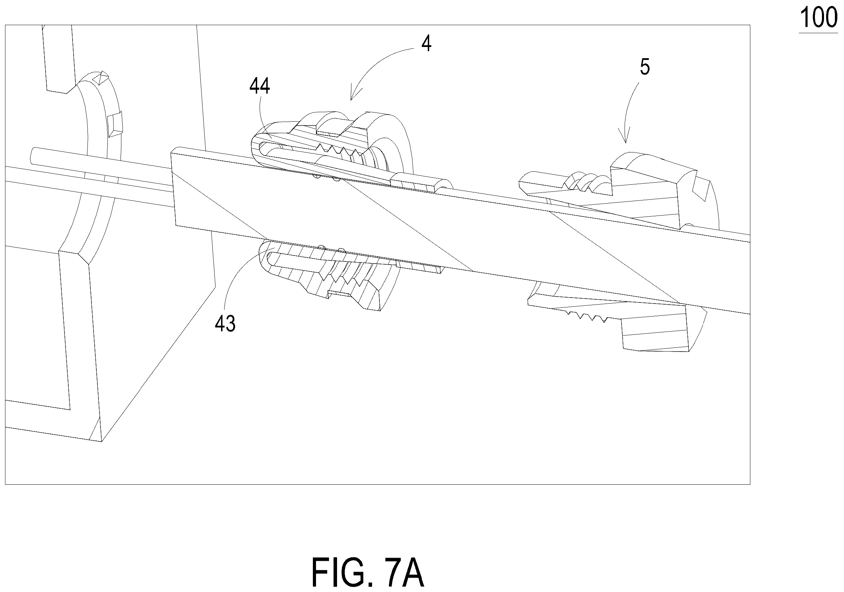

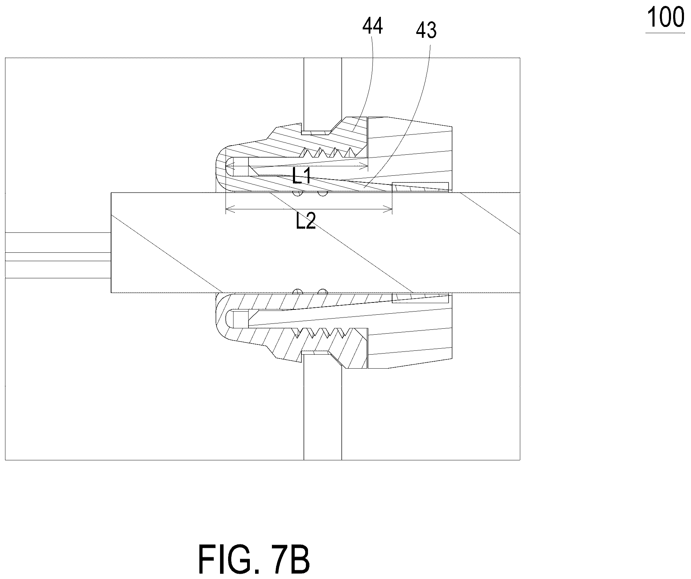

FIG. 7A is a structural section drawing illustrating the relationship between a waterproof fixing device and a housing of an electronic device according to a sixth embodiment of the present disclosure. FIG. 7B is a schematic cross-sectional view illustrating the assembled structure of the waterproof fixing device and the housing of the electronic device according to the sixth embodiment of the present disclosure.

Please refer to FIGS. 7A and 7B. The structures and functions of the waterproof fixing device and the electronic device of this embodiment are similar to those of the first embodiment. Component parts and elements corresponding to those of the first embodiment are designated by identical numeral references, and detailed descriptions thereof are omitted. In the waterproof fixing device and the electronic device of this embodiment, the end 434 of the inner ring structure 43 and the corresponding end of the outer ring structure 44 are not aligned with each other. That is, the first length L1 and the second length L2 are not equal. For example, as shown in FIG. 7B, the end 434 of the inner ring structure 43 is protruded over the corresponding end of the outer ring structure 44. That is, the first length L1 is shorter than the second length L2. Consequently, the contact area between the outer surface 431 of the inner ring structure 43 and the inner surface 522 of the wall structure 52 is large enough to improve the waterproof performance. It is noted that numerous modifications may be made. For example, in another embodiment, the end of the outer ring structure 44 is protruded over the end 434 of the inner ring structure 43. That is, the first length L1 is greater than the second length L2.

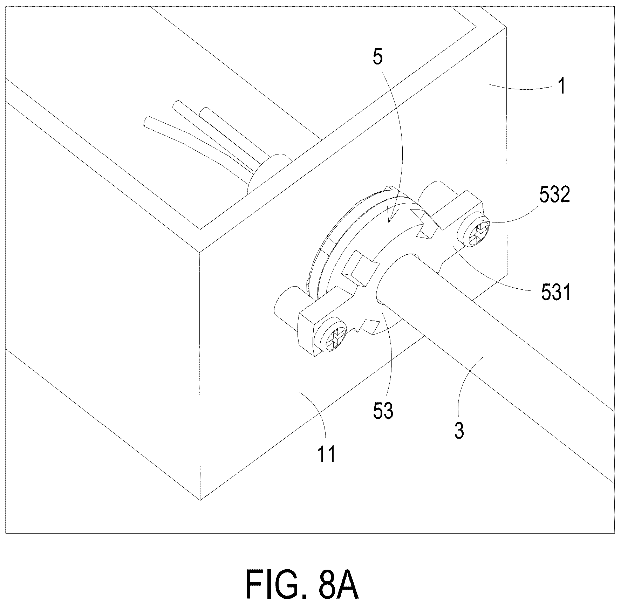

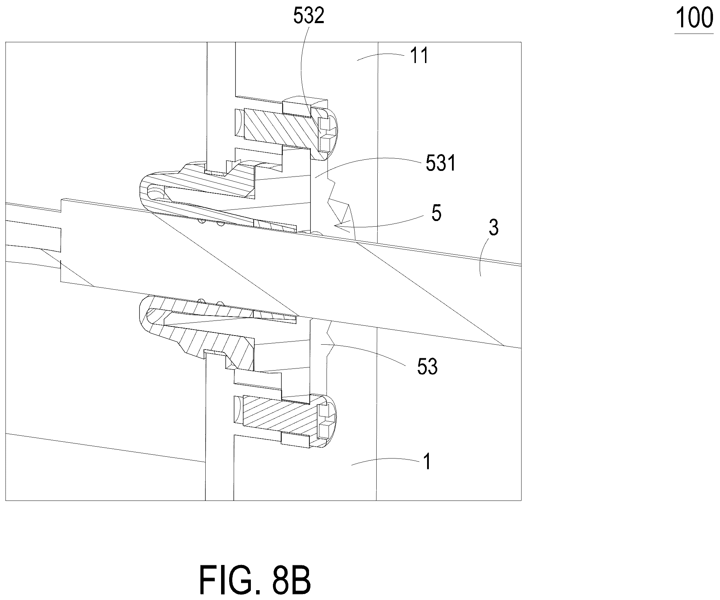

FIG. 8A is a structural diagram illustrating the assembled structure of a waterproof fixing device and a housing of an electronic device according to a seventh embodiment of the present disclosure. FIG. 8B is a structural section drawing illustrating assembled structure of the waterproof fixing device and the housing of electronic device according to the seventh embodiment of the present disclosure.

Please refer to FIGS. 8A and 8B. The structures and functions of the waterproof fixing device and the electronic device of this embodiment are similar to those of the first embodiment. Component parts and elements corresponding to those of the first embodiment are designated by identical numeral references, and detailed descriptions thereof are omitted. In the waterproof fixing device and the electronic device with same of this embodiment, the second sealing element 5 further includes a protruding top portion 53. The protruding top portion 53 is connected with an end of the tubular portion 51 and attached on an end of the outer ring structure 44. Moreover, the second sealing element 5 includes at least one extension portion 531 and a plurality of locking components 532. The extension portion 531 is extended from the protruding top portion 53 and extended in a direction parallel to an outer surface of the side wall 11 of the housing 1. In some embodiments, the second sealing element 5 includes two extension portion 531 arranged on opposite sides of the protruding top portion 53. The extension portion 531 has a plurality of fixing holes. These locking components are penetrated through the corresponding fixing holes of the extension portion 531 and tightened into the corresponding screw holes of the housing 1. Consequently, the extension portion 531 is fixed on the side wall 11 of the housing 1. In some embodiments, the locking component are screws. In some embodiments, the first sealing element 4 is not equipped with the internal thread 443, and the second sealing element 5 is not equipped with the external thread 526. Under this circumstance, the second sealing element 5 is assembled with the first sealing element 4 in a non-screwing manner. Instead, the second sealing element 5 is fixed on the side wall 11 of the housing 1 through the plurality of locking components 532. Consequently, the second sealing element 5 and the first sealing element 4 can be tightly fitted into the through hole 12 of the housing 1. In this embodiment, the manufacturing difficulty of the components is reduced while achieving the similar fixing purpose and the waterproof sealing purpose.

From the above descriptions, the present disclosure provides a waterproof fixing device and an electronic device with the waterproof fixing device. The waterproof fixing device includes a cable, a first sealing element and a second sealing element. The first sealing element is sheathed around the outer surface of the cable. The first sealing element and the second sealing element are assembled with each other and tightly fitted in the through hole of the housing of the electronic device to achieve the waterproof purpose. In accordance with the waterproof fixing device of the present disclosure, fewer components are used, the assembled structure is simple, the assembly time is reduced, and the sealing effect between the cable and the through hole of the housing is enhanced. Consequently, the overall waterproof performance is improved. Moreover, the waterproof fixing device can be applied to different types of through holes, such as the through holes with chamfers or counterbores. In addition, the waterproof fixing device has high adaptability to various wall thicknesses of the housing. Consequently, the applications are wide.

## Claims

1. A waterproof fixing device (2), **characterized by** comprising:
a cable (3) having an outer surface (31);
a first sealing element (4) comprising:
a fixing component (41) comprising an inner ring structure (43), an outer ring structure (44) and an accommodation space (45), wherein the inner ring structure (3) has a first channel (433), the cable (3) is penetrated through the first channel (433), the outer ring structure (44) is connected to and arranged around the inner ring structure (43), and the accommodation space (45) is located between the inner ring structure (43) and the outer ring structure (44); and
a flexible component (42) assembled with the fixing component (41), wherein at least a portion of the flexible component (42) is attached on the outer surface (31) of the cable (3); and
a second sealing element (5) comprising a tubular portion (51), wherein the tubular portion (51) comprises a wall structure (52), the wall structure (52) is accommodated within the accommodation space (45) of the first sealing element (4), and an inner surface (522) and an outer surface (521) of the wall structure (52) are respectively attached on an outer surface (431) of the inner ring structure (43) and an inner surface (442) of the outer ring structure (44).

2. The waterproof fixing device according to claim 1, wherein the flexible component (42) comprises at least one first waterproof structure (46), wherein the at least one first waterproof structure (46) is an annular or sheet-like structure, and the at least one first waterproof structure (46) is disposed on an inner surface (432) of the inner ring structure (43) and is attached on the outer surface (31) of the cable (3).

3. The waterproof fixing device according to claim 2, wherein the inner surface (432) of the inner ring structure (43) is completely covered by the at least one first waterproof structure (46).

4. The waterproof fixing device according to anyone of claims 1-3, wherein the flexible component (42) comprises a second waterproof structure (47), and the second waterproof structure (47) is an annular structure, wherein the second waterproof structure (47) is disposed on an end (434) of the inner ring structure (43) and extended in a direction parallel to an axial of the first channel (433), wherein an inner surface (472) and an outer surface (471) of the second waterproof structure (47) are respectively attached on the outer surface (31) of the cable (3) and the inner surface (522) of the wall structure (52).

5. The waterproof fixing device according to claim 4, wherein the flexible component (42) further comprises a waterproof ring (49), and the waterproof ring (49) is arranged around an outer surface (441) of the outer ring structure (44).

6. The waterproof fixing device according to claim 4, wherein the fixing component (41) of the first sealing element (4) further comprises a first arc-shaped portion (P1) and a second arc-shaped portion (P2), wherein the first arc-shaped portion (P1) and the second arc-shaped portion (P2) are separated from each other, and a gap (411) is formed between the first arc-shaped portion (P1) and the second arc-shaped portion (P2), wherein a portion of the inner ring structure (43), a portion of the outer ring structure (44) and a portion of the accommodation space (45) are collaboratively formed as the first arc-shaped portion (P1), and another portion of the inner ring structure (43), another portion of the outer ring structure (44) and another portion of the accommodation space (45) are collaboratively formed as the second arc-shaped portion (P2), wherein the flexible component (42) further comprises a third waterproof structure (48), and the third waterproof structure (48) is disposed within the gap (411) and attached on the outer surface (31) of the cable (3), wherein the first arc-shaped portion (P1) and the second arc-shaped portion (P2) are made of metallic material, plastic material or elastic material, wherein the third waterproof structure (48) is connected with the at least one first waterproof structure (46) and the second waterproof structure (47) to integrally form as a one-piece structure.

7. The waterproof fixing device according to claim 1, wherein the fixing component (41) further comprises a limiting structure (412), wherein the limiting structure (412) is disposed on an outer surface (441) of the outer ring structure (44), the limiting structure (412) comprises two protrusions (413) and a groove (414), the two protrusions (413) are protruded from the outer surface (441) of the outer ring structure (44) and arranged around the outer ring structure (44), and the groove (414) is defined by the two protrusions (413) and the outer surface (441) of the outer ring structure (44), wherein the flexible component (42) comprises a waterproof ring (49), and the waterproof ring (49) is circumferentially disposed in the groove (414), wherein the limiting structure (412) further comprises at least one first limiting portion (415), and the at least one first limiting portion (415) is extended from one of the two protrusions (413) and towards the groove (414).

8. The waterproof fixing device according to claim 1, wherein the outer ring structure (44) and the inner ring structure (43) of the first sealing element (4) in a direction parallel to an axial direction of the first channel (433) have a first length (L1) and a second length (L2), respectively, wherein the first length (L1) and the second length (L2) are different, or wherein the outer ring structure (44) and the inner ring structure (43) of the first sealing element (4) in a direction parallel to an axial direction of the first channel (433) have a first length (L1) and a second length (L2), respectively, wherein the first length (L1) and the second length (L2) are equal.

9. The waterproof fixing device according to claim 1, wherein the second sealing element (5) further comprises a protruding top portion (53), and the protruding top portion (53) is connected with an end of the tubular portion (51) and attached on an end of the outer ring structure (44), wherein the tubular portion (51) further comprises a second channel (523), and the inner ring structure (43) of the fixing component (41) is accommodated within the second channel (523).

10. The waterproof fixing device according to claim 9, wherein the fixing component (41) of the first sealing element (4) further comprises a connecting portion (451), and the connecting portion (451) is connected between the inner ring structure (43) and the outer ring structure (44), wherein a first end of the outer surface (431) of the inner ring structure (43) close to the connecting portion (451) has a first outer diameter (D1), a second end of the outer surface (431) of the inner ring structure (43) away from the connecting portion (451) has a second outer diameter (D2), and the first outer diameter (D1) is greater than the second outer diameter (D2), wherein the second channel (523) of the tubular portion (51) of the second sealing element (5) comprises a first opening (524) and a second opening (525) opposite to the first opening (524), the first opening (524) is away from the protruding top portion (53) and has a first inner diameter (R1), and the second opening (525) is located near the protruding top portion (53) and has a second inner diameter (R2), wherein the first inner diameter (R1) is greater than the second inner diameter (R2), wherein the first inner diameter (R1) and the first outer diameter (D2) are equal, and the second inner diameter (R2) and the second outer diameter (D2) are equal.

11. The waterproof fixing device according to claim 1, wherein the outer surface (521) of the wall structure (52) of the tubular portion (51) of the second sealing element (5) has an external thread (526), and the inner surface (442) of the outer ring structure (44) of the first sealing element (4) has an internal thread (443), wherein the external thread (526) and the internal thread (443) are engaged with each other, so that the second sealing element (5) is assembled with the first sealing element (4), or wherein the flexible component (42) is made of silicone, rubber, or thermoplastic polyurethane (TPU).

12. The waterproof fixing device according to claim 1, wherein the fixing component (41) of the first sealing element (4) further comprises a first arc-shaped portion (P1), a second arc-shaped portion (P2) and a connecting structure (P3), wherein the connecting structure (P3) is connected between the first arc-shaped portion (P1) and the second arc-shaped portion (P2), a gap (411) is formed between the first arc-shaped portion (P1) and the second arc-shaped portion (P2), and the first arc-shaped portion (P1), the second arc-shaped portion (P2) and the connecting structure (P3) are collaboratively formed as a one-piece structure, wherein a portion of the inner ring structure (43), a portion of the outer ring structure (44) and a portion of the accommodation space (45) are collaboratively formed as the first arc-shaped portion (P1), and another portion of the inner ring structure (43), another portion of the outer ring structure (44) and another portion of the accommodation space (45) are collaboratively formed as the second arc-shaped portion (P2), wherein the flexible component (42) comprises a third waterproof structure (48), and the third waterproof structure (48) is disposed within the gap (411) and attached on the outer surface (31) of the cable (3), wherein the first arc-shaped portion (P1) and the second arc-shaped portion (P2) are made of plastic material or elastic material.

13. An electronic device (100), **characterized by** comprising:
a housing (1) comprising a side wall (11), wherein the side wall (11) has a through hole (12); and
a waterproof fixing device (2) assembled with the housing (1), wherein the waterproof fixing device (1) comprises:
a cable (3) having an outer surface (31);
a first sealing element (4) comprising:
a fixing component (41) comprising an inner ring structure (43), an outer ring structure (44) and an accommodation space (45), wherein the inner ring structure (43) has a first channel (433), the cable (3) is penetrated through the first channel (433), the outer ring structure (44) is connected to and arranged around the inner ring structure (43), and the accommodation space (45) is located between the inner ring structure (43) and the outer ring structure (44); and
a flexible component (42) assembled with the fixing component (41), wherein at least a portion of the flexible component (42) is attached on the outer surface (31) of the cable (3); and
a second sealing element (5) comprising a tubular portion (51), wherein the tubular portion (51) comprises a wall structure (52), the wall structure (52) is accommodated within the accommodation space (45) of the first sealing element (4), and an inner surface (522) and an outer surface (521) of the wall structure (52) are respectively attached on an outer surface (431) of the inner ring structure (43) and an inner surface (422) of the outer ring structure (44),
wherein the cable (3) of the waterproof fixing device (2) is extended through the through hole (12) of the side wall (11) of the housing (1), and the first sealing element (4) is fitted and fixed into the through hole (12) of the side wall (11) of the housing (1).

14. The electronic device according to claim 13, wherein the fixing component (41) further comprises a limiting structure (412), wherein the limiting structure (412) is disposed on an outer surface (441) of the outer ring structure (44), the limiting structure (412) comprises two protrusions (413) and a groove (414), the two protrusions (413) are protruded from the outer surface (441) of the outer ring structure (44) and arranged around the outer ring structure (44), and the groove (414) is defined by the two protrusions (413) and the outer surface (441) of the outer ring structure (44), wherein the flexible component (42) comprises a waterproof ring (49), and the waterproof ring (49) is circumferentially disposed in the groove (414), wherein the limiting structure (412) comprises a first limiting portion (415), and the first limiting portion (415) is extended from one of the two protrusions (413) and towards the groove (414), wherein the housing (1) further comprises a second limiting portion (14) corresponding to the first limiting portion (415), and the second limiting portion (14) is arranged on an inner periphery (13) of the through hole (12) of the side wall (11), wherein the first limiting portion (415) of the fixing component (41) and the second limiting portion (14) of the housing (1) are engaged with each other.

15. The electronic device according to claim 13, wherein the second sealing element (5) further comprises a protruding top portion (53), and the protruding top portion (53) is connected with an end of the tubular portion (51) and attached on an end of the outer ring structure (44), wherein the protruding top portion (53) comprises an extension portion (531) and a locking component (532), wherein the extension portion (531) is extended from the protruding top portion (53) and extended in a direction parallel to the side wall (11) of the housing (1), and the extension portion (531) has a fixing hole, wherein the locking component (532) is penetrated through the fixing hole of the extension portion (531) and tightened into the housing (1), so that the extension portion (531) is fixed on the side wall (11) of the housing (1).
